(19) Europäisches Patentamt
European Patent Office
Office européen des brevets

(11) **EP 4 641 544 A1**

(12) **EUROPEAN PATENT APPLICATION**

(43) Date of publication:
**29.10.2025 Bulletin 2025/44**

(21) Application number: **25172253.4**

(22) Date of filing: **24.04.2025**

(51) International Patent Classification (IPC):
**G09B 9/08** (2006.01)     **G09B 9/10** (2006.01)
**G09B 9/12** (2006.01)

(52) Cooperative Patent Classification (CPC):
**G09B 9/12; G09B 9/08; G09B 9/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **26.04.2024 US 202463639487 P**

(71) Applicant: **Loft Dynamics AG
8600 Dübendorf (CH)**

(72) Inventors:
• **Danuser, Gian
  8600 Dübendorf (CH)**
• **Marty, Christian
  8600 Dübendorf (CH)**

(74) Representative: **Bittner, Bernhard
Hannke Bittner & Partner
Patent- und Rechtsanwälte mbB
Prüfeninger Strasse 1
93049 Regensburg (DE)**

(54) **STATE-DEPENDENT MOTION CUEING**

(57) A motion cueing system for a flight simulator includes a motion system controller configured to generate actuation commands for a movable simulator platform. The actuation commands are based on at least one of: an absolute attitude of a simulated aircraft; or a weighted function of a groundspeed of the simulated aircraft.

FIG. 1

## Description

Cross Reference to Related Applications

This application claims benefit of U.S. Provisional Application Serial No. 63/639,487 entitled, "State-Dependent Motion Cueing" filed April 26, 2024, the entire disclosure of which is incorporated herein by reference.

Field of the Disclosure

The present disclosure relates to aircraft simulation systems. The disclosure has particular utility in state-dependent motion cueing used with aircraft simulation systems, and will be described in connection with such utility, although other utilities are contemplated.

Background and Summary

This section provides background information related to the present disclosure which is not necessarily prior art. This section provides a general summary of the disclosure and is not a comprehensive disclosure of its full scope or all its features.

Flight simulation is used to artificially generate aircraft flight and an environment in which the aircraft flies, for pilot training, design, or other purposes. Flight simulators typically virtually recreate situations of aircraft flight, including how aircraft react to applications of flight controls, the effects of other aircraft systems, and how the aircraft reacts to external factors such as air density, turbulence, wind shear, clouds, precipitation, etc. Flight simulation is used for a variety of reasons, including flight training pilots, the design and development of the aircraft itself, and research into aircraft characteristics and control handling qualities. Some simulations are based on previously recorded flights which are virtually recreated for a pilot.

Current flight simulators simulate motion cues for pilots and crew members by using a perception model-based filter based on the characteristics of the human vestibular system. These conventional systems aim to provide motion cues to the human sensory system that match the cues perceived in aircraft in reality, as much as possible, for pilots to perform the training tasks required. Motion cues often take the form of movements to the simulation environment based on a change in simulated aircraft attitude, which is the angular difference measured between an axis of the aircraft and the line of the Earth's horizon. Aircraft attitude is typically recognized as including pitch attitude, e.g., the angular difference measured along the longitudinal axis of an aircraft, and bank attitude, e.g., the angular difference measured along the lateral axis of the aircraft.

Typically, motion cues in a simulated environment are achieved by positioning the attitude of the physical simulation platform differently from the attitude of the simulated aircraft, especially when the simulated aircraft is experiencing forces other than gravity (e.g., centrifugal force). As an example, the simulation of forward aircraft acceleration requires a momentary acceleration of the simulation platform in the forward direction (surge) to provide the onset cueing. This is considered the direct transfer relationship. The simulation platform, however, is simultaneously pitched nose-up due to the motion drive algorithm (MDA) low-pass filter in order to generate a sustained specific force. Traditional cueing models use the high-pass characteristics of the vestibular system to overcome adverse cueing that is unrealistic due to the limited range of motion systems. These washout filters drive the motion systems back to neutral after the relevant acceleration or angular velocity cues are provided to the pilot. Persistent lateral or longitudinal forces are usually cued to pilots by tilting the platform below the perception threshold.

Helicopter pilots are more trained to use motion cues to fly the aircraft in comparison to pilots only trained on fixed-wing aircraft. Motion effects that do not reflect the aircraft behavior, like washout filters, are very disturbing for pilots and obfuscate other cues of the body, such as pressure points in the seat, that are used to estimate the attitude of the aircraft. This is especially important when the aircraft is hovering, when no kinematic effects due to aircraft motion are present.

Standard motion cueing filters are not ideal at simulating the absolute attitude of an aircraft because they incorporate washout filters that position a physical simulation platform to a neutral attitude - different from that of the simulated aircraft. This provides adverse cueing to the pilots and interferes with them performing the training tasks on the simulator.

To improve over these limitations of conventional simulation systems, the present disclosure is directed to a motion cueing system which generates actuation commands for a physical simulator platform, such as a movable cockpit platform, using a weighting system based on groundspeed to balance between outputs from both a motion cueing filter based on the human vestibular system and the state of the aircraft in simulation.

In one embodiment, a motion cueing system for a flight simulator includes a motion system controller configured to generate actuation commands for a movable cockpit platform. The actuation commands are based on at least one of: an absolute attitude of a simulated aircraft; or a weighted function of a groundspeed of the simulated aircraft.

In one aspect of this embodiment, the weighting function of the groundspeed of the simulated aircraft further comprises a linear ramp function.

In this aspect, the weighting function of the groundspeed of the simulated aircraft further comprises a low-pass filter receiving an output from the linear ramp function.

In another aspect of this embodiment, the weighting system outputs a weight and an inverse weight.

In this aspect, the motion cueing system further includes a first multiplication function multiplying the weight by target roll and pitch attitudes of the simulated aircraft to produce weighted target roll and pitch attitudes, and a second multiplication function multiplying the inverse weight by the absolute attitude of the simulated aircraft to produce weighted absolute roll and pitch attitudes.

Moreover, in this aspect, a summation module may be used for summing the weighted target roll and pitch attitudes and the weighted absolute roll and pitch attitudes to produce a target roll and pitch of the simulated aircraft, wherein the motion system controller generates the actuation commands based on the target roll and pitch of the simulated aircraft.

In another embodiment, a computerized motion cueing system for a flight simulator is provided, where the computerized motion cueing system has at least a processor and a non-transitory memory. The computerized motion cueing system includes a weighting system receiving an aircraft groundspeed value from a flight simulation device, wherein the weighting system outputs a weight and an inverse weight, wherein weighted target roll and pitch attitudes are generated based on the weight, and weighted absolute roll and pitch attitudes are generated based on the inverse weight. A motion system controller receives a summation of the weighted target roll and pitch attitudes and the weighted absolute roll and pitch attitudes. Actuation commands are generated by the motion system controller, wherein a movable cockpit platform is moved based on the actuation commands.

In one aspect of this embodiment, the weighting system has a weighting function of the groundspeed of the simulated aircraft, wherein the weighting function further comprises a linear ramp function.

In this aspect, the weighting function of the groundspeed of the simulated aircraft further comprises a low-pass filter receiving an output from the linear ramp function.

In another aspect, the weighted target roll and pitch attitudes are generated with a first multiplication function multiplying the weight by target roll and pitch attitudes of the simulated aircraft, and the weighted absolute roll and pitch attitudes are generated with a second multiplication function multiplying the inverse weight by the absolute attitude of the simulated aircraft.

In this aspect, a summation module generates the summation of the weighted target roll and pitch attitudes and the weighted absolute roll and pitch attitudes based on the first multiplication function and the second multiplication function.

In yet another aspect, a motion cueing filter generates the target roll and pitch attitude and a target position and yaw.

In one example of this aspect, the motion cueing filter includes a force scaler and an angular velocity scaler, wherein the force scaler and the angular velocity scaler multiply translational accelerations and angular velocities from the flight simulation device with scaling constants to generate a value correlated to a human vestibular system.

In yet another aspect, a motion trajectory optimizer limits at least one of: a motion of the movable cockpit platform; or an actuator speed of the movable cockpit platform.

In other embodiments, a method of motion cueing for a flight simulator is provided. In this regard, one embodiment of such a method, among others, can be broadly summarized by the following steps: generating, with a motion system controller, actuation commands for a movable cockpit platform, wherein the actuation commands are based on at least one of: an absolute attitude of a simulated aircraft; or a weighting function of a groundspeed of the simulated aircraft.

In one aspect, the weighting function of the groundspeed of the simulated aircraft further comprises a linear ramp function.

In this aspect, the weighting function of the groundspeed of the simulated aircraft further comprises a low-pass filter receiving an output from the linear ramp function.

In another aspect, the weighting system outputs a weight and an inverse weight.

In this aspect, the method includes multiplying, with a first multiplication function, the weight by target roll and pitch attitudes of the simulated aircraft to produce weighted target roll and pitch attitudes, and multiplying, with a second multiplication function, the inverse weight by the absolute attitude of the simulated aircraft to produce weighted absolute roll and pitch attitudes.

In this aspect, the method includes summing, with a summation module, the weighted target roll and pitch attitudes and the weighted absolute roll and pitch attitudes to produce a target roll and pitch of the simulated aircraft, wherein the motion system controller generates the actuation commands based on the target roll and pitch of the simulated aircraft.

Further areas of applicability will become apparent from the description provided herein. The description and specific examples in this summary are intended for purposes of illustration only and are not intended to limit the scope of the present disclosure.

Brief Description of the Drawings

Further features and advantages of the disclosure will be seen in the following detailed description, taken in conjunction with the accompanying drawings. The drawings described herein are for illustrative purposes only of selected embodiments and not all possible implementations and are not intended to limit the scope of the present disclosure.

In the drawings:

FIG. 1 is a diagrammatic illustration of a motion cueing system for a flight simulator, in accordance with the present disclosure;

FIG. 2 is a diagrammatic illustration of a weighting system used by the motion cueing system for a flight simulator of FIG. 1, in accordance with the present disclosure;

FIG. 3 is a diagrammatic illustration of a motion cueing filter used by the motion cueing system for a flight simulator of FIG. 1, in accordance with the present disclosure; and

FIG. 4 is a diagrammatic illustration of a movable cockpit platform used by the motion cueing system for a flight simulator of FIG. 1, in accordance with the present disclosure.

Detailed Description

Example embodiments will now be described more fully with reference to the accompanying drawings. Example embodiments are provided so that this disclosure will be thorough and will fully convey the scope to those who are skilled in the art. Numerous specific details are set forth such as examples of specific components, devices, and methods to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail.

The terminology used herein is for the purpose of describing particular example embodiments only and is not intended to be limiting. As used herein, the singular forms "a," "an," and "the" may be intended to include the plural forms as well, unless the context clearly indicates otherwise. The terms "comprises," "comprising," "including," and "having" are inclusive and therefore specify the presence of stated features, integers, steps, operations, elements, components, and/or groups, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on," "engaged to," "connected to," or "coupled to" another element or layer, it may be directly on, engaged, connected or coupled to the other element or layer, or intervening elements or layers may be present. In contrast, when an element is referred to as being "directly on," "directly engaged to," "directly connected to," or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

Although the terms first, second, third, etc. may be used herein to describe various elements, components, regions, layers, and/or sections, these elements, components, regions, layers, and/or sections should not be limited by these terms. These terms may be only used to distinguish one element, component, region, layer or section from another element, component, region, layer, or section. Terms such as "first," "second," and other numerical terms when used herein do not imply a sequence or order unless clearly indicated by the context. Thus, a first element, component, region, layer, or section discussed below could be termed a second element, component, region, layer, or section without departing from the teachings of the example embodiments.

Spatially relative terms, such as "inner," "outer," "beneath," "below," "lower," "above," "upper," and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The present disclosure is directed to a motion cueing system which generates actuation commands for a physical simulator platform using a weighting system based on groundspeed to balance between outputs from both a motion cueing filter based on the human vestibular system and a true representation of the state of the aircraft in simulation. In particular, the present disclosure has particular utility to motion cueing in a movable cockpit platform of aircraft operating at low groundspeeds.

Low groundspeed operations occur when helicopters and other vertical take-off and landing aircraft (VTOLs) are hovering, such as during vertical reference flight or sling load operations. Using aircraft simulation state to generate actuation commands for the physical simulator platform allows users to feel attitude and attitude changes of the simulated aircraft accurately at low groundspeed. Piloting based on the forces exerted by the pilot's seat on the pilot sitting therein, which are feelings of absolute attitude, is an important skill for hover operations, as the human vestibular system is inaccurate when pilots lose sight of the horizon, which is common in sling load operations as pilots look down at the load, and when the aircraft has low groundspeed.

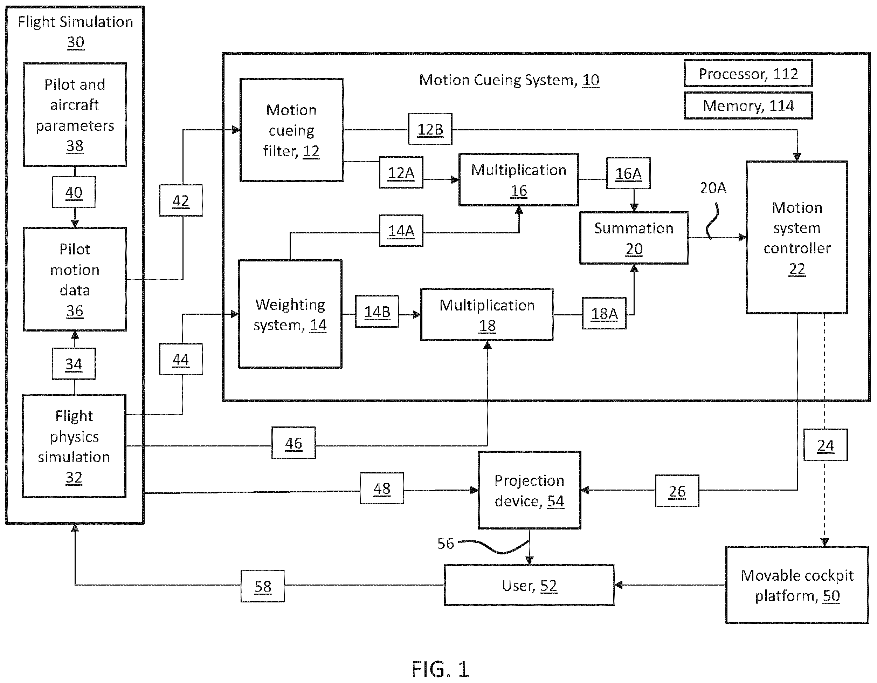

FIG. 1 is a diagrammatic illustration of a motion cueing system 10 for a flight simulator, in accordance with the present disclosure. As shown, motion cueing system 10 is in communication with, and receives inputs from, a flight simulation device 30, and outputs actuation commands to a flight simulator, such as movable cockpit platform 50.

Flight simulation device 30 includes a flight physics simulation module 32 which records the simulated aircraft state 34 of a simulated aircraft, and outputs the simulated aircraft state 34 to a pilot motion data module 36. Flight simulation device 30 also includes a parameters module 38 having parameters of the simulated pilot and simulated aircraft. This parameter data 40 is output to pilot motion data module 36. Other components may also be included in flight simulation device 30.

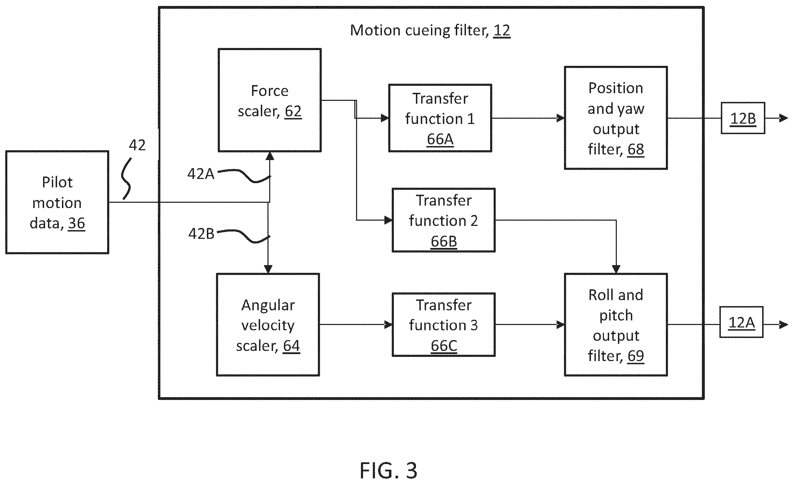

In operation, at a given time, e.g., at a first timestep, a pilot motion data module 36 processes simulated aircraft state 34 data from flight physics simulation module 32 and parameters 40 of pilot and aircraft parameters module 38, and calculates angular velocity and acceleration 42 that should be felt by the simulated pilot. Angular velocity and acceleration 42 is output to motion cueing system 10, specifically, to a motion cueing filter 12 which calculates the target position and attitude of movable cockpit platform 50 correlated with, or based on, a vestibular model of the human body, to create an accurate simulated feeling of a moving aircraft for the user. This process is described in further detail relative to FIG. 3.

Simultaneously to the output of angular velocity and acceleration 42 to motion cueing filter 12, and calculation of the target position and attitude of movable cockpit platform 50, simulated aircraft state 34 data of flight simulation module 30 transmits aircraft groundspeed 44, such as in the form of an aircraft groundspeed value, to a weighting system 14 having a weighting function, which returns a weight 14A, denoted as $w$ and an inverse weight 14B, denoted as $1 - w$, based on aircraft groundspeed 44. The inverse weight 14B may be defined as the additive inverse of weight 14A. The weight 14A is multiplied in a first multiplication function 16 with motion system target roll and pitch attitudes 12A provided by motion cueing filter 12. It is noted that multiplication function 16 may operate in various manners. For example, in one embodiment, multiplication function 16 multiplies weight 14A with the input roll and pitch attitudes 12A, whereas in another embodiment, multiplication function 16 may transform input roll and pitch attitude 12A before and/or after multiplication with weight 14A.

The inverse weight 14B is multiplied at second multiplication function 18 with absolute attitude data of the simulated aircraft, namely, absolute roll and pitch attitudes 46 from flight physics simulation module 32. Weighted motion system target roll and pitch attitudes 16A from multiplication function 16 are summed at a summation module 20 with the weighted absolute roll and pitch attitudes 18A from multiplication function 18, to return a target roll and pitch 20A.

Motion system controller 22 receives, as an input, motion system target position and yaw attitude 12B from motion cueing filter 12, along with target roll and pitch 20A from summation module 20, and generates actuation commands 24 which are provided to movable cockpit platform 50. Movable cockpit platform 50 is capable of physical movements to position user 52 of the simulator in a body position such that they feel an accurate simulation of the aircraft acceleration, attitude, and attitudinal acceleration, among other kinematic components. For example, movable cockpit platform 50 may have various actuators which change a physical position of the movable cockpit platform 50. Additionally, flight simulation information 48 from flight simulation module 30 and visual motion information 26 from motion system controller 22 is passed to a projection device 54, which may be a virtual reality headset, a projection screen, or another type of projection system, which generates visuals 56 for user 52 to see. Based, at least in part, on the simulation of kinematic components to user 52, user 52 may input control commands 58 to flight simulation module 30, which among other inputs, changes the simulated aircraft state 34 at the next timestep. While depicted separately in FIG. 1, the movable cockpit platform 50 may be a substantially unitary structure in which or on which the user 52 and the projection device 54 are located.

Motion cueing system 10 may be formed, in whole or part, from a computerized device, a computerized system, or a combination thereof. Motion cueing system 10 may have at least one processor 112 capable of executing instructions to perform computations, including computations associated with motion cueing filter 12, weighting system 14, multiplication functions 16, 18, a summation function of summation module 20, or other aspects of the motion cueing system 10. At least one non-transitory memory 114 is included in the motion cueing system 10, and is in communication with at least the processor 112. Other hardware components may be included with motion cueing system 10, including communication devices, input/output devices, databases, and the like, and various software components may be used without limitation.

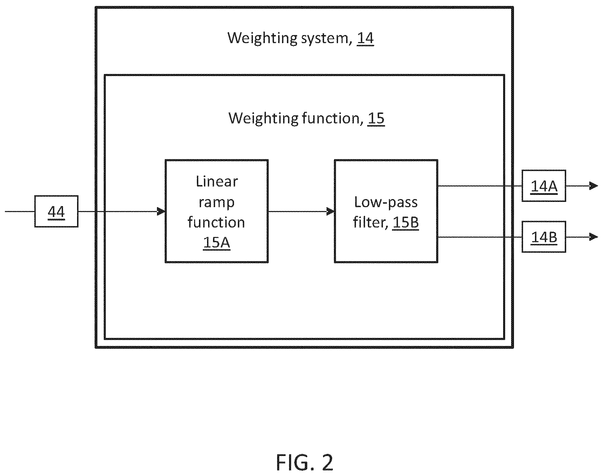

FIG. 2 is a diagrammatic illustration of a weighting system 14 used by motion cueing system 10 for a flight simulator of FIG. 1, in accordance with the present disclosure. With reference to FIGS. 1-2, weighting system 14 may use a weighting function 15 which receives, as an input, groundspeed 44 and returns a weight 14A $w$ that is in the interval [0, 1]. In one embodiment, weighting function 15 is a monotonically increasing function. In a specific example, as shown in FIG. 2, weighting function 15 may include a linear ramp function 15A bounded between 0 and 1 whose output passes through a low-pass filter 15B, where linear ramp function 15A is in the

form:

$$w = \max(\min(ax + b, 0), 1)$$

where $x$ is the groundspeed 44, and $a$ and $b$ are constants determined such that absolute roll and pitch attitude 46 is more strongly represented in summation module 20 when groundspeed 44 is below a certain threshold that depends on the parameter $b$, and motion system target roll and pitch attitude 12A is more strongly represented when groundspeed 44 is above a certain threshold also depending on the parameter $b$. The parameter $a$ may control the steepness of the transition from one motion cueing system to another, such that system 10 can provide smooth transitions between different motion cueing systems.

$$a = \frac{1}{10\,\text{knots}}$$

In one embodiment, and $b = 0$, and low-pass filter 15B has a time constant $\tau = 2$.

In another embodiment, the weighting function 15 is a sigmoidal function of the form:

$$w = \frac{1}{1 + e^{-a(x-b)}}$$

FIG. 3 is a diagrammatic illustration of a motion cueing filter 12 used by motion cueing system 10 for a flight simulator of FIG. 1, in accordance with the present disclosure. With reference to FIGS. 1 and 3, the motion cueing filter 12 may include a force scaler 62 component and an angular velocity scaler 64 component, which multiply translational accelerations 42A and angular velocities 42B given by pilot angular velocity and acceleration 42 from pilot motion data module 36 with scaling constants to generate a value correlated to, or appropriate for, the human vestibular system. The output of force scaler 62 is passed to a first transfer function 66A, whose output is then passed through a position and yaw output filter 68 and returns motion system target position and yaw 12B. The output of force scaler 62 is also passed to a second transfer function 66B, which is combined with the output of a third transfer function 66C whose input is from angular velocity scaler 64 in the roll and pitch output filter 69, which outputs motion system target roll and pitch 12A.

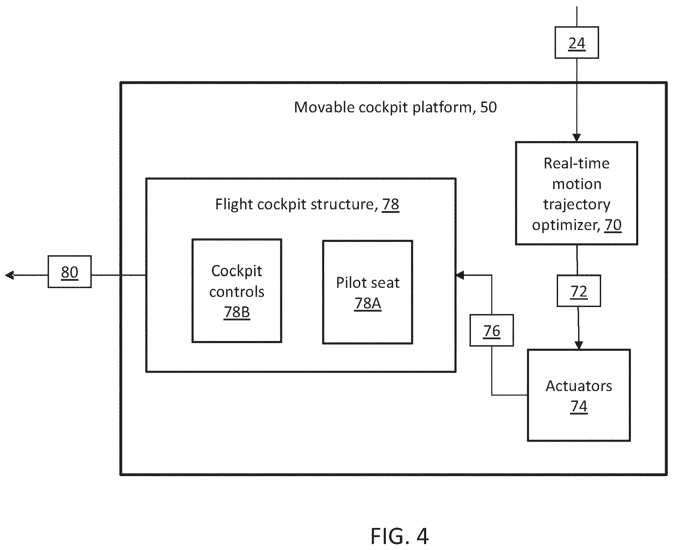

The motion system target position and yaw 12B and the target roll and pitch 20A from the summation module 20, as shown in FIG. 1, are used by motion system controller 22 to generate actuation commands 24. FIG. 4 is a diagrammatic illustration of a movable cockpit platform 50 used by motion cueing system 10 for a flight simulator of FIG. 1, in accordance with the present disclosure. Relative to FIGS. 1 and 4, actuation commands 24 returned by motion control system 22 are passed to a real-time motion trajectory optimizer 70 which is within or in communication with movable cockpit platform 50. Real-time motion trajectory optimizer 70 adjusts the input to take into account other factors and outputs modified actuation commands 72. In one embodiment, these modified actuation commands 72 include the limits of motion of the movable cockpit platform 50 whereas in another embodiment, they include the limits of how fast actuators 74 can move, e.g., by limiting an actuator speed of the movable cockpit platform. The modified actuation commands 72 are passed to actuators 74, which initiate physical motion signal 76 to physically move simulated flight cockpit structure 78. The actuators 74 can include but are not limited to devices such as pistons, linear actuators, and/or vibration actuators, or others. The flight cockpit structure 78 may include devices that simulate a real aircraft cockpit, such as a pilot seat 78A that user 52 sits in, and cockpit controls 78B that user 52 uses to send control commands 58. The movement of the flight cockpit structure 78 generates user body movement (at 80) that is felt by user 52, such that user 52 experiences the desired simulated motion.

It should be noted that any process descriptions or blocks in flow charts should be understood as representing modules, segments, portions of code, or steps that include one or more instructions for implementing specific logical functions in the process, and alternate implementations are included within the scope of the present disclosure in which functions may be executed out of order from that shown or discussed, including substantially concurrently or in reverse order, depending on the functionality involved, as would be understood by those reasonably skilled in the art of the present disclosure.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure. Various changes and advantages may be made in the above disclosure without departing from the spirit and scope thereof.

List of references

| 10 | motion cueing system |
| 12 | motion cueing filter |
| 12A | target roll and pitch attitudes |
| 12B | target position and yaw attitude |
| 14 | weighting system |
| 14A | weight |
| 14B | inverse weight |

15   weighting function
15A   linear ramp function
15B   low-pass filter
16   multiplication function
16A   weighted roll and pitch attitudes
18   multiplication function
18A   weighted roll and pitch attitudes
20   summation module
20A   roll and pitch
22   motion system controller
24   actuation commands
26   visual motion information
30   flight simulation device
32   flight physics simulation module
34   simulated aircraft state
36   pilot motion data module
38   aircraft parameters module
40   parameter data
42   angular velocity and acceleration
42A   translational accelerations
42B   angular velocities
44   aircraft groundspeed
46   roll and pitch attitudes
48   flight simulation information
50   movable cockpit platform
52   user
54   projection device
56   visuals
58   control commands
62   force scaler
64   angular velocity scaler
66A   first transfer function
66B   second transfer function
66C   third transfer function
68   position and yaw output filter
69   roll and pitch output filter
70   motion trajectory optimizer
72   modified actuation commands
74   actuators
76   physical motion signal
78   flight cockpit structure
78A   pilot seat
78B   cockpit controls
80   user body movement
112   processor
114   non-transitory memory

**Claims**

1.  A motion cueing system for a flight simulator comprising:
    a motion system controller configured to generate actuation commands for a movable cockpit platform, wherein the actuation commands are based on at least one of:

    an absolute attitude of a simulated aircraft; or
    a weighting function of a groundspeed of the simulated aircraft.

2.  The motion cueing system of claim 1, wherein the weighting function of the groundspeed of the simulated aircraft further comprises a linear ramp function.

3.  The motion cueing system of claim 2, wherein the weighting function of the groundspeed of the simulated aircraft further comprises a low-pass filter receiving an output from the linear ramp function.

4.  The motion cueing system of claims 1, 2, or 3 wherein the weighting system outputs a weight and an inverse weight.

5.  The motion cueing system of claim 4, further comprising:

    a first multiplication function multiplying the weight by target roll and pitch attitudes of the simulated aircraft to produce weighted target roll and pitch attitudes; and
    a second multiplication function multiplying the inverse weight by the absolute attitude of the simulated aircraft to produce weighted absolute roll and pitch attitudes.

6.  The motion cueing system of claim 5, further comprising a summation module summing the weighted target roll and pitch attitudes and the weighted absolute roll and pitch attitudes to produce a target roll and pitch of the simulated aircraft, wherein the motion system controller generates the actuation commands based on the target roll and pitch of the simulated aircraft.

7.  The motion cueing system of claim 5, wherein weighted target roll and pitch attitudes are generated based on the weight, and weighted absolute roll and pitch attitudes are generated based on the inverse weight.

8.  The motion cueing system of claim 5, further comprising a motion cueing filter generating the target roll and pitch attitude and a target position and yaw.

9.  The motion cueing system of claim 8, wherein the motion cueing filter further comprises a force scaler and an angular velocity scaler, wherein the force scaler and the angular velocity scaler multiply translational accelerations and angular velocities from the flight simulation device with scaling constants to generate a value correlated to a human vestibular system.

10. The motion cueing system of claims 1, 2, or 3, further comprising a motion trajectory optimizer which limits at least one of: a motion of the movable cockpit platform; or an actuator speed of the movable cockpit platform.

11. A method of motion cueing for a flight simulator, the method comprising:
generating, with a motion system controller, actuation commands for a movable cockpit platform, wherein the actuation commands are based on at least one of:

an absolute attitude of a simulated aircraft; or
a weighting function of a groundspeed of the simulated aircraft.

12. The method of claim 11, wherein the weighting function of the groundspeed of the simulated aircraft further comprises a linear ramp function.

13. The method of claim 12, wherein the weighting function of the groundspeed of the simulated aircraft further comprises a low-pass filter receiving an output from the linear ramp function.

14. The method of claims 11, 12, or 13, wherein the weighting system outputs a weight and an inverse weight.

15. The method of claim 14, further comprising:

multiplying, with a first multiplication function, the weight by target roll and pitch attitudes of the simulated aircraft to produce weighted target roll and pitch attitudes; and
multiplying, with a second multiplication function, the inverse weight by the absolute attitude of the simulated aircraft to produce weighted absolute roll and pitch attitudes.

16. The method of claim 15, further comprising summing, with a summation module, the weighted target roll and pitch attitudes and the weighted absolute roll and pitch attitudes to produce a target roll and pitch of the simulated aircraft, wherein the motion system controller generates the actuation commands based on the target roll and pitch of the simulated aircraft.

FIG. 1

FIG. 2

FIG. 3

FIG. 4

Europäisches Patentamt
European Patent Office
Office européen des brevets

# EUROPEAN SEARCH REPORT

**Application Number**

EP 25 17 2253

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NUSSECK H-G ET AL: "Learning System Dynamics:Transfer of Training in a Helicopter Hover Simulator", PROCEEDINGS. AIAA MODELING AND SIMULATION TECHNOLOGIES CONFERENCE, XX, XX , no. AIAA 2008-7107 18 August 2008 (2008-08-18), pages 1-11, XP002639719, Retrieved from the Internet: URL:http://www.kyb.mpg.de/fileadmin/user_upload/files/publications/attachments/AIAA2008-Nusseck_5340%5B0%5D.pdf [retrieved on 2011-05-31] | 1-5, 11-15 | INV. G09B9/08 G09B9/10 G09B9/12 |
| A | * page 3 - page 4; figures 1-3 * | 6,16 | |
| X | MEMON WAJIH A. ET AL: "Motion Fidelity Requirements for Helicopter-Ship Operations in Maritime Rotorcraft Flight Simulators", JOURNAL OF AIRCRAFT, vol. 56, no. 6, 1 November 2019 (2019-11-01), pages 2189-2209, XP093312141, ISSN: 1533-3868, DOI: 10.2514/1.C035521 * Nomenclature; figures 1-4 * | 1,9,11 | |

**TECHNICAL FIELDS SEARCHED (IPC)**

G09B

The present search report has been drawn up for all claims

| Place of search | Date of completion of the search | Examiner |
|---|---|---|
| Munich | 8 September 2025 | Liendl, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 641 544 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63639487